# EUROPÄISCHE PATENTSCHRIFT

(11) **EP 1 922 910 B1**
(45) Veröffentlichungstag und Bekanntmachung des Hinweises auf die Patenterteilung: **08.06.2011**
(21) Anmeldenummer: 06777951.2
(22) Anmeldetag: 25.07.2006
(51) Int. Cl.: H05K 9/00, H01R 13/658

(54) **ABSCHIRMGEHÄUSE MIT EINPRESSPINS SOWIE VERFAHREN ZU DESSEN HERSTELLUNG**
SCREENED HOUSING WITH PRESS-FIT PINS AND METHOD FOR PRODUCTION THEREOF
BOITIER DE BLINDAGE COMPORTANT DES BROCHES A INSERTION ET PROCEDE DE FABRICATION

(30) Priorität: 05.09.2005 DE 102005042131
(43) Veröffentlichungstag der Anmeldung: 21.05.2008
(73) Patentinhaber: Continental Automotive GmbH, 30165 Hannover (DE)
(72) Erfinder: MEYER, Frank, 93083 Obertraubling (DE); PUSCHER, Wolfgang, 93073 Neutraubling (DE)
(86) Internationale Anmeldenummer: PCT/EP2006/064618
(87) Internationale Veröffentlichungsnummer: WO 2007/028668

(56) Entgegenhaltungen:
- DE-U1- 29 808 620
- US-A- 5 967 846
- US-A1- 2002 025 720
- US-B1- 6 217 378

## Beschreibung

Die Erfindung betrifft ein Abschirmgehäuse mit Einpresspins zur elektrischen Kontaktierung auf einer elektrischen Trägerkomponente, insbesondere für den Automobilbereich, wobei das Abschirmgehäuse aus zwei Gehäuseteilen zusammengesetzt ist, die jeweils einen Gehäuseboden mit jeweils zwei Gehäuserändern mit Einpresspins aufweisen.

Um elektronische Bauteile oder Schaltkreise gegenüber elektromagnetischer Ab- und Einstrahlung zu schirmen, werden Abschirmgehäuse oder Tunerboxen verwendet. Diese müssen sowohl elektrisch gut an die Leiterplatte angebunden sein als auch rundum entsprechend der Strahlungsfrequenz elektrisch "dicht" sein, d. h. bestimmte Spaltbreiten dürfen nicht überschritten werden.

Denkbar ist die Verwendung von Abschirmgehäusen mit Lötpins bzw. Verschränk- oder Verdrilllaschen oder mit Oberflächen montierten Bauelementen in SMD-Technik.

Aus der US 5,967,846 A ist ein Abschirmgehäuse der eingangs genannten Gattung bekannt. Bei dem vorbekannten Abschirmgehäuse besteht das Abschirmgehäuse aus zwei Gehäuseteilen, die mit Hilfe einer Steckverbindung miteinander verbunden sind.

Aus der DE 101 02 459 A1 ist ein Gehäuse für ein steckbar mit dem Gehäuse verbindbares elektrisches Bauteil bekannt, das Befestigungspins zu seiner Befestigung an einer Leiterplatte aufweist, sowie ein Verfahren zur Montage eines derartigen Gehäuses an einer Leiterplatte. Die Befestigungspins sind unter Ausbildung einer Pressfit-Verbindung mit der Leiterplatte verbindbar. Das Verfahren zeichnet sich dadurch aus, dass zunächst der Stecker für ein elektronisches Bauteil mit der Leiterplatte verlötet und getestet und anschließend das Gehäuse über den Stecker und auf die Leiterplatte aufgesetzt wird, wobei die Befestigungspins unter Ausbildung einer Pressfit-Verbindung mit der Leiterplatte verbunden werden.

Unter der Bezeichnung Pressfit-Verbindung werden Verbindungen verstanden, die allein durch Einstecken der Befestigungspins in entsprechende Öffnungen der Leiterplatte eine Verbindung zwischen den Pins und der Leiterplatte herstellen, ohne dass es weiterer Montageschritte wie z. B. verlöten oder kleben bedarf. Pressfit-Verbindungen können sowohl formschlüssige als auch kraftschlüssige Verbindungen sein.

Soll zur Anwendung des Abschirmgehäuses an die Leiterplatte die bekannte Einpresstechnik eingesetzt werden, so müssen an allen vier Umfangsflächen des Gehäuses die entsprechende Anzahl Pressfit-Kontakte, die an die Strahlungsfrequenz gekoppelt ist, vorhanden sein. In einer Blechabwicklung dargestellt, bedeutet dies, dass in allen vier Richtungen für die vier Umfangsflächen auch vier Stanz-/ Prägestationen bereitgestellt werden müssen. Alternativ dazu ist es bekannt, nur an zwei sich gegenüberliegenden Umfangsseiten Einpresspins anzuordnen, während an denen um 90° versetzten Umfangsseiten Federelemente verwendet werden, die den Kontakt zur Leiterplatte über Anpressdruck herstellen.

Dieser Aufbau für ein Folgeverbundwerkzeug ist jedoch sehr kostenintensiv, so dass die Endprodukte einem Preisvergleich mit konventionell hergestellten Tunerboxen in Löt-, Schweiß- oder einer anderen Verbindungstechnik nicht standhalten. Somit ist die Verwendung von Abschirmgehäusen mit Einpresspins trotz gravierender Vorteile bei der Endmontage solcher Einpressgehäuse auf Elektronikbaugruppen unrentabel.

Hiervon ausgehend liegt der vorliegenden Erfindung die Aufgabe zugrunde, ein kostengünstiges Abschirmgehäuse zu schaffen, dessen Herstellungsverfahren auf einfache Art und Weise in einem Folgeverbundwerkzeug durchführbar ist.

Diese Aufgabe wird durch ein Abschirmgehäuse mit den Merkmalen des Patentanspruchs 1 sowie durch ein Verfahren zu dessen Herstellung mit den Merkmalen des Patentanspruchs 5 gelöst. Vorteilhafte Aus- und Weiterbildungen, welche einzeln oder in Kombination miteinander eingesetzt werden können, sind der Gegenstand der abhängigen Ansprüche.

Das erfindungsgemäße Abschirmgehäuse mit Einpresspins zeichnet sich dadurch aus, dass es aus zwei Gehäuseteilen zusammengesetzt ist, die jeweils einen Gehäuseboden mit jeweils zwei Gehäuserändern mit Einpresspins aufweisen. Die baugleich ausgeformten Gehäuseteile sind Vorstanzstreifen mit gegenüberliegend, also an parallelen Seiten angeordneten Einpresspins, die als Endlosband in einem Folgeverbundwerkzeug ähnlich einem Pinstanzwerkzeug kostengünstig gefertigt werden können. Dabei hat die Anzahl der Einpresspins pro Seite keinen wesentlichen Einfluss auf den Werkzeug- bzw. Teilepreis, da dafür nur die Taktzeit ausschlaggebend ist. Somit ist also ein enges Raster der Einpresspins möglich. Auf zusätzliche Federelemente zur Erreichung der geforderten Spaltmaße kann verzichtet werden, so dass auch die dafür benötigten Biegeprozesse entfallen. Da keine Federelemente vorgesehen sind, wird die Funktionsfähigkeit des Abschirmgehäuses sicherer, zumal eine Einpressverbindung eine gasdichte, sichere elektrische Verbindung ist. Außerdem ermöglicht die Verwendung von Einpresspins eine einfache Prozessüberwachung der Montage des Abschirmgehäuses auf einer elektrischen Trägerkomponente wie zum Beispiel einer Leiterplatte durch einfache Pinanwesenheitskontrolle. Die optische Kontrolle der Federelemente auf Verbiegung kann hingegen entfallen. Das erfindungsgemäße Abschirmgehäuse bietet auch den Vorteil, dass es keine Einheitsgröße aufweist. Da erst durch den Trennschritt und den Biegeprozess die endgültige Gehäuseform ausgebildet wird, sind verschiedene Gehäusevarianten herstellbar. Das Folgeverbundwerkzeug für die Vorstanzstreifen kann so flexibel ausgeführt werden, dass durch die Vergrößerung des Abstandes zwischen den Stanz- und Prägematrizen verschiedene Breiten der Vorstanzstreifen schnell realisiert werden können. Weitere Vorteile ergeben sich für die Lackierprozesse bzw. für die Prüfung der Funktionstätigkeit der Bauelemente mit optischer und elektrischer Standardausrüstung, da die Montage des Abschirmgehäuses nachträglich ohne Wärmezufuhr erfolgen kann.

Erfindungsgemäß sind die Gehäuseteile um 90° gegeneinander verdreht aneinander befestigt, so dass die Anordnung der Einpresspins an parallel zueinander verlaufenden Seiten der Gehäuseteile dazu führt, dass an allen vier Umfangseiten des Abschirmgehäuses Einpresspins angeordnet sind.

Erfindungsgemäß ist vorgesehen, dass die Gehäuseteile am Gehäuseboden aneinander befestigt sind, so dass verschiedene Verbindungstechniken, wie zum Beispiel Verprägen, Clinchen, Schweißen, Toxen durchgeführt werden können.

Vorteilhaft ist, dass der Gehäuseboden in variabler Breite ausstanzbar ist, so dass verschiedene Gehäusegrößen hergestellt werden können.

Von Vorteil ist, wenn die parallel zueinander verlaufenden Gehäuseränder der Gehäuseteile an den seitlichen Enden Verankerungsmittel aufweisen. Diese Verankerungsmittel bieten eine sichere Befestigung der um 90° gegeneinander verdreht angeordneten Gehäuseteile und reduzieren die Spaltbreite in den Ecken.

Es ist bevorzugt, dass das Abschirmgehäuse Taschen zur Krafteinleitung und zur Aufnahme des Einpresswerkzeugs aufweist. Da sich diese Taschen in der Sollknickstelle befinden, vereinfachen sie zudem das Umbiegen der Gehäuseränder.

Das erfindungsgemäße Verfahren zur Herstellung eines Abschirmgehäuses mit Einpresspins umfasst die Schritte: Stanzen und Prägen eines endlosen Blechstreifens mit an zwei parallelen Seiten angeordneten Einpresspins; Ausstanzen zweier Gehäuseteile aus dem Blechstreifen, Umbiegen der Einpresspins aufweisenden Gehäuseränder um 90° und Verbinden der Gehäuseteile verliersicher und elektrisch leitend miteinander an ihren Gehäuseböden durch Punkschweißen, Verprägen, Toxen oder Clinchen. Durch das erfindungsgemäße Verfahren in einem Folgeverbundwerkzeug mit abschließendem Verbindungsschritt wird eine einfache und kostengünstige Herstellung von Abschirmgehäusen mit an allen vier Umfangsseiten angeordneten Einpresspins ermöglicht. Durch das Verfahren können Abschirmgehäuse in unterschiedlichen Größen hergestellt werden, da die Breite der Gehäuseteile beim Ausstanzen variiert werden kann.

Die vorliegende Erfindung schafft erstmals vorteilhaft ein Abschirmgehäuse mit an allen vier Umfangseiten angeordneten Einpresspins, das auf einfache und kostengünstige Weise in einem Folgeverbundwerkzeug hergestellt werden kann. Derartige Abschirmgehäuse eignen sich insbesondere für den Automobilbereich, um elektronische Bauteile oder Schaltkreise gegenüber elektromagnetische Ab- und Einstrahlung zu schirmen.

Weitere Vorteile und Ausführungen der Erfindung werden nachfolgend anhand von Ausführungsbeispielen sowie anhand der Zeichnung erläutert.

Dabei zeigen schematisch:
- Fig. 1: in einer perspektivischen Darstellung ein Ausführungs- beispiel eines erfindungsgemäßen Abschirmgehäuses mit Einpresspins und
- Fig. 2a bis 2d: in einer Draufsicht die einzelnen Verfahrens- schritte des erfindungsgemäßen Herstellungsverfahrens für ein Abschirmgehäuse mit Einpresspins.

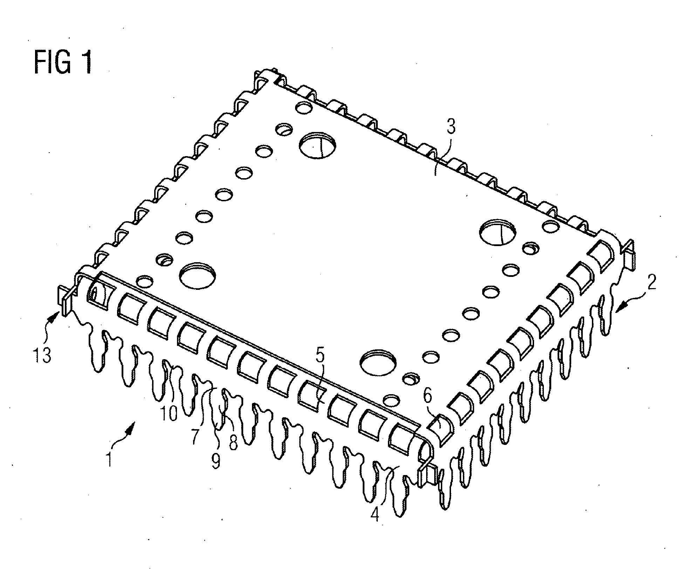

Fig. 1 zeigt in einer perspektivischen Darstellung ein Ausführungsbeispiel eines erfindungsgemäßen Abschirmgehäuse 1 mit Einpresspins 2. Das Abschirmgehäuse 1 weist einen vorzugsweise rechteckigen Gehäuseboden 3 auf, der an allen vier Umfangseiten in Gehäuseränder 4 mündet, die um 90° zum Gehäuseboden 3 umgebogen sind, so dass das Abschirmgehäusen 1 insgesamt wannenförmig ausgeformt ist. Um das Umbiegen der Gehäuseränder 4 zu erleichtern, ist der Übergang vom Gehäuseboden 3 zu den Gehäuserändern 4 als Sollknickstelle 5 ausgebildet. Die Sollknickstelle 5 weist vorzugsweise in gleichem Abstand zueinander angeordnete Taschen 6 auf, die das Umbiegen der Gehäuseränder 4 erleichtern. Die Taschen 6 dienen zudem zur Aufnahme des Einpresswerkzeugs. Somit ist eine Krafteinwirkung direkt unter den Einpresspins 2 in ihrer Längsrichtung möglich. Die Gehäuseränder 4 weisen außerdem die vorzugsweise in gleichem Abstand zueinander angeordneten Einpresspins 2 auf. Die Gehäuseränder 4 münden über einen Übergangsbereich 7, der sich in Richtung der Einpresspins verengt in einen bauchig ausgeformten Bereich 8 der Einpresspins 2. Dieser bauchig ausgeformte Bereich 8 mündet schließlich in pfeilförmig ausgebildete Spitzen 9 der Einpresspins.

Zwischen den Einpresspins 2 und vorzugsweise alternierend mit diesen sind Lippen 10 in den Gehäuserändern 4 angeordnet, die die Spaltbreite zwischen dem Abschirmgehäuse und den Leiterplatten minimieren und stabilisierend wirken. Zudem sind jeweils an den Randbereichen rechts und links der sich parallel gegenüberliegenden Gehäuseränder 4 Schlitze 11 angeordnet, die als Verankerungsmittel 13 dienen, um die Gehäuseränder 4 fest aneinander zu befestigen und die Spaltbreite in den Ecken zu reduzieren.

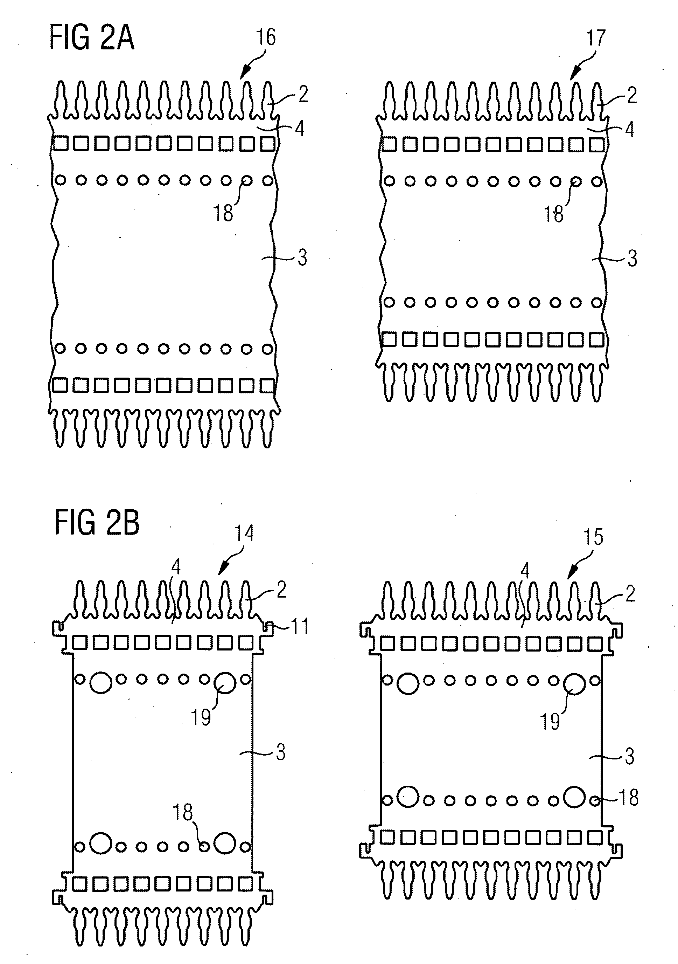

Die Fig. 2a bis 2d zeigen in einer Draufsicht die einzelnen Verfahrensschritte des erfindungsgemäßen Herstellungsverfahrens für ein Abschirmgehäuse 1 mit Einpresspins 2. Dabei zeigt Fig. 2a zwei separate Vorstanzstreifen 16, 17 in unterschiedlicher Breite mit gegenüberliegend angeordneten Einpresspins 2, die als Endlosband in einem Folgeverbundwerkzeug gefertigt werden. Die Vorstanzstreifen 16, 17 weisen den Gehäuseboden 3 sowie an zwei parallel zueinander angeordneten Seiten Gehäuseränder 4 auf, die in die Einpresspins 2 münden. Im Gehäuseboden 3 sind kleine parallel zu den Gehäuserändern 4 verlaufende Durchgriffsbohrungen 18 angeordnet, die den Vorschub in Transferrichtung (TR) im Werkzeug ermöglichen. Sowohl die Taschen 6 als auch die Durchgriffsbohrungen 18 und die Einpresspins 2 werden in einem Stanzhub gefertigt. Dies führt dazu, dass die Einpresspins 2, die Taschen 6 sowie die Durchgriffsbohrungen 18 alle in einem identischen Raster liegen und identische Abmaße in Querrichtung zur Transferrichtung aufweisen.

Fig. 2b zeigt zwei vom Vorstanzstreifen 16, 17 ausgestanzte fertige Gehäuseteile (14, 15), die durch den Trennschritt ihre füge- und montagespezifische (Stanzen der Verankerungsmittel) Geometrie erhalten mit Gehäuseboden 3, Gehäuserändern 4 und Einpresspins 2, Taschen 6 und Durchgriffsbohrungen 18. Im Gehäuseboden 3 können zusätzlich zu den Durchgriffsbohrungen 18 für den Vorschub noch weitere Ausstanzungen 19 mit montagespezifischer Geometrie vorgesehen sein, die nach der Montage des Abschirmgehäuses 1 an einer elektrischen Trägerkomponente, wie zum Beispiel einer Leiterplatte als Durchkontaktierungen für weitere elektrische Komponenten dienen.

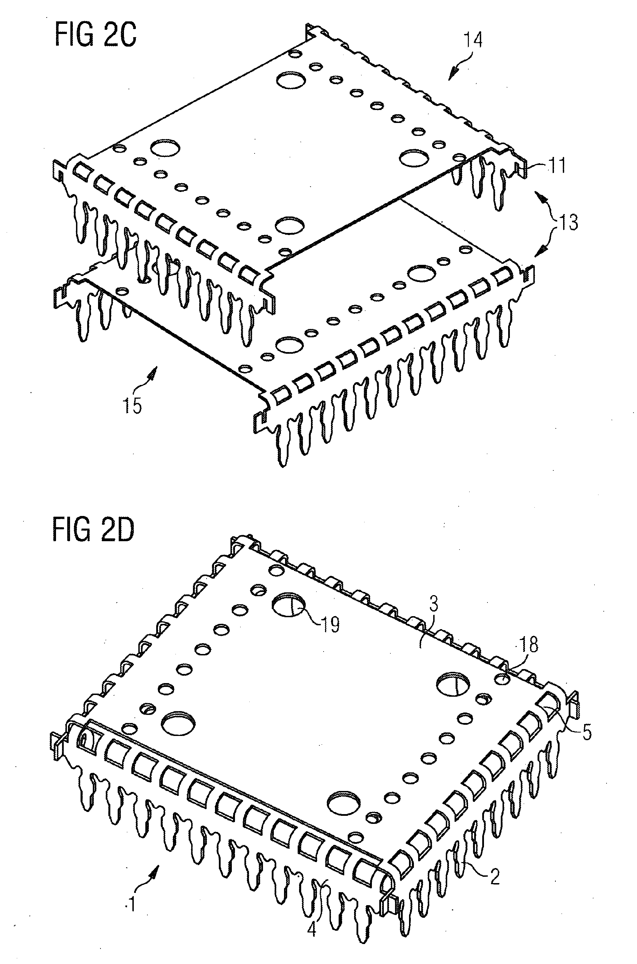

Fig. 2c zeigt die Gehäuseteile 14, 15 nach dem Umbiegen der Gehäuseränder 4, wie sie um 90° gegeneinander verdreht werden, so dass an allen vier Umfangseiten des erfindungsgemäßen Abschirmgehäuses 1 Einpresspins 2 angeordnet sind. Das erfindungsgemäße Abschirmgehäuse 1 ist somit zweiteilig ausgebildet.

Fig. 2d zeigt das erfindungsgemäße Abschirmgehäuse 1, nachdem die beiden Gehäuseteile 14, 15 verliersicher und elektrisch leitend miteinander durch Punktschweißen, Verprägen, Toxen oder Clinchen verbunden worden sind.

Das erfindungsgemäße Verfahren zur Herstellung eines Abschirmgehäuses (1) mit Einpresspins (2) umfasst die Schritte: Stanzen und Prägen eines endlosen Blechstreifens mit an zwei parallelen Seiten angeordneten Einpresspins (2), Ausstanzen zweier Gehäuseteile (14, 15) aus dem Blechstreifen, Umbiegen der Einpresspins (2) aufweisenden Randbereiche um 90°, verdrehen der Gehäuseteile um 90° gegeneinander und Verbinden der Gehäuseteile (14, 15) verliersicher und elektrisch leitend miteinander an ihren Gehäuseböden durch Punkschweißen, Verprägen, Toxen oder Clinchen.

Die vorliegende Erfindung schafft erstmals vorteilhaft ein Abschirmgehäuse (1) mit an allen vier Umfangseiten angeordneten Einpresspins (2), das auf einfache und kostengünstige Weise in einem Folgeverbundwerkzeug hergestellt werden kann. Derartige Abschirmgehäuse (1) eignen sich insbesondere für den Automobilbereich, um elektronische Bauteile oder Schaltkreise gegenüber elektromagnetischer Ab- und Einstrahlung zu schirmen.

## Patentansprüche

1. Abschirmgehäuse (1) mit Einpresspins (2) zur elektrischen Kontaktierung auf einer elektrischen Trägerkomponente, insbesondere für den Automobilbereich, wobei das Abschirmgehäuse (1) aus zwei Gehäuseteilen (14, 15) zusammengesetzt ist, die jeweils einen Gehäuseboden (3) mit jeweils zwei Gehäuserändern (4) mit Einpresspins (2) aufweisen, **dadurch gekennzeichnet, dass** die Gehäuseteile (14, 15) um 90° gegeneinander verdreht aneinander befestigt sind, wobei die Gehäuseteile (14, 15) am Gehäuseboden (3) verliersicher und elektrisch leitend miteinander durch Punktschweißen, Verprägen, Toxen oder Clinchen verbunden sind.

2. Abschirmgehäuse (1) nach Anspruch 1, **dadurch gekennzeichnet, dass** der Gehäuseboden (3) in variabler Breite ausstanzbar ist.

3. Abschirmgehäuse (1) nach einem der vorhergehenden Ansprüche, **dadurch gekennzeichnet, dass** die Gehäuseteile (14, 15) jeweils zwei parallel zueinander verlaufende Gehäuseränder (4) aufweisen, die jeweils an den Enden Verankerungsmittel (13) aufweisen.

4. Abschirmgehäuse (1) nach einem der vorhergehenden Ansprüche, **dadurch gekennzeichnet, dass** das Abschirmgehäuse (1) Taschen (6) zur Krafteinleitung und zur Aufnahme eines Einpresswerkzeugs aufweist.

5. Verfahren zur Herstellung eines Abschirmgehäuses (1) mit Einpresspins (2) zur elektrischen Kontaktierung auf einer elektrischen Trägerkomponente, insbesondere für den Automobilbereich, mit den Schritten:
- Stanzen und Prägen eines endlosen Blechstreifens mit an zwei parallelen Seiten angeordneten Einpresspins (2);
- Ausstanzen zweier Gehäuseteile (14, 15) aus dem Blechstreifen;
- Umbiegen der Einpresspins (2) aufweisenden Randbereiche um 90°;
- Verdrehen der Gehäuseteile (14, 15) um 90° gegeneinander;
- Verbinden der Gehäuseteile (14, 15) verliersicher und elektrisch leitend miteinander an ihren Gehäuseböden durch Punktschweißen, Verprägen, Toxen oder Clinchen.

## Claims

1. Screening housing (1) having press-fit pins (2) for making electrical contact on an electrical support component, in particular for the automobile sector, with the screening housing (1) being composed of two housing parts (14, 15) which each have a housing base (3) with in each case two housing edges (4) having press-fit pins (2), **characterized in that** the housing parts (14, 15) are attached to one another such that they are rotated through 90° with respect to one another, with the housing parts (14, 15) being connected to one another at the housing base (3) in a captive and electrically conductive manner by spot-welding, stamping, toxing or clinching.

2. Screening housing (1) according to Claim 1, **characterized in that** the housing base (3) can be punched out with a variable width.

3. Screening housing (1) according to either of the preceding claims, **characterized in that** the housing parts (14, 15) each have two housing edges (4) which run parallel to one another and which each have anchoring means (13) at the ends.

4. Screening housing (1) according to one of the preceding claims, **characterized in that** the screening housing (1) has pockets (6) for introducing force and for accommodating a press-fit tool.

5. Method for producing a screening housing (1) having press-fit pins (2) for making electrical contact on an electrical support component, in particular for the automobile sector, comprising the steps of:
- punching and stamping an endless strip of sheet metal having press-fitpins (2) arranged on two parallel sides;
- punching out two housing parts (14, 15) from the strip of sheet metal;
- bending the edge regions which have press-fitpins (2) through 90°;
- rotating the housing parts (14, 15) through 90° with respect to one another;
- connecting the housing parts (14, 15) to one another in a captive and electrically conductive manner at their housing bases by spot-welding, stamping, toxing or clinching.

## Revendications

1. Boîtier de blindage (1), comportant des broches de pressage (2) pour la réalisation de contacts électriques sur un composant de support électrique, en particulier pour le secteur automobile, ledit boîtier de blindage (1) étant composé de deux parties de boîtier (14, 15), qui comportent chacune un fond de boîtier (3) avec respectivement deux bords boîtier (4) munis de broches de pressage (2), **caractérisé en ce que** les parties de boîtier (14, 15) sont fixées l'une à l'autre, l'une étant tournée de 90° par rapport à l'autre, les parties de boîtier (14, 15) étant assemblées l'une à l'autre au niveau du fond (3) du boîtier, de manière inamovible et électro-conductrice, par soudage par points, par estampage, par clinchage Tox ou par rivetage.

2. Boîtier de blindage (1) selon la revendication 1, **caractérisé en ce que** le fond (3) du boîtier peut être découpé par poinçonnage dans des largeurs variables.

3. Boîtier de blindage (1) selon l'une quelconque des revendications précédentes, **caractérisé en ce que** les parties de boîtier (14, 15) comportent respectivement deux bords de boîtier (4) au tracés parallèles l'un à l'autre, qui présentent respectivement des moyens d'ancrage (13) au niveau des extrémités.

4. Boîtier de blindage (1) selon l'une quelconque des revendications précédentes, **caractérisé en ce que** ledit boîtier de blindage (1) présente des poches (6) pour l'introduction de forces et pour le logement d'un outil de pressage.

5. Procédé pour la réalisation d'un boîtier de blindage (1) comprenant des broches de pressage (2) pour la réalisation de contacts électriques sur un composant de support électrique, en particulier pour le secteur automobile, comprenant les étapes :
- poinçonnage et estampage d'une bande de tôle en continu munie de broches de pressage (2) disposées de deux côtés parallèles ;
- découpe par poinçonnage de deux parties de boîtier (14, 15) dans la bande de tôle ;
- pliage de 90° des zones de bordure munies de broches de pressage (2) ;
- rotation des parties de boîtier (14, 15) de 90° en sens inverse l'une par rapport à l'autre ;
- assemblage des parties de boîtier (14, 15) de manière inamovible et électro-conductrice, au niveau de leurs fonds de boîtier, par soudage par points, par estampage, par clinchage Tox ou par rivetage.
